# EUROPEAN PATENT APPLICATION

(11) **EP 1 006 651 A2**
(43) Date of publication of application: **07.06.2000**
(21) Application number: 99123918.7
(22) Date of filing: 02.12.1999
(51) Int. Cl.: H03H 9/17

(54) **Piezoelectric resonator**

(30) Priority: 04.12.1998 JP 37643398
(71) Applicant: Watanabe, Takaya, Aoba-ku, Yokohama City, Kanagawa (JP)
(72) Inventor: Watanabe, Takaya, Aoba-ku, Yokohama City, Kanagawa (JP)
(74) Representative: Reinhard - Skuhra - Weise & Partner

(57) **Abstract**

On a piezoelectric plate (made, for example, of quartz, lithium tantalate, lithium niobate, piezoelectric ceramics) 100, inner electrodes 102 and outer electrodes 101, 105 of a round or rectangular shape are disposed with a gap 103 therebetween, and a lead electrode 104 is connected to the outer electrode 101. On the back face of the piezoelectric plate, an outer electrode 105 and a lead electrode 106 are provided at positions corresponding to electrodes provided on the front side. By employing this extremely simple electrode structure, it is possible to suppress jittering and a jumping phenomenon in which ocsillation jumps among harmonic modes. The piezoelectric resonator of the present invention is capable of producing an oscillation output of extreme stability and high purity and does not require a filter to suppress undesired oscillation modes in the output.

## Description

### Background of the Invention

### Field of the Invention

The present invention is applicable to a crystal resonator which utilizes thickness oscillations and a similar piezoelectric resonator made of a piezoelectric material other than quartz, such as lithium tantalate, lithium niobate or piezoelectric ceramics. The present invention relates more particularly to an electrode structure for piezoelectric resonators used for the purpose of enhancing the function of piezoelectric resonators used for microprocessors, computers, various telecommunication devices, etc. in the fields of mobile communication or information processing for cellular telephones when particularly high performances are required.

### Description of Related Art

When smaller sizes and higher performance are required for such devices as cellular telephones, the crystal resonator is indispensable. The types of crystal resonators known so far include the temperature compensation type crystal resonator (TCXO), digital temperature compensation type crystal resonator (D-TCXO), and voltage control type crystal resonator (VCXO), and various crystal resonators are realized by combining the crystal resonator with LSI, resistors, capacitors, and other passive parts. Also, as a clock source for computers in the field of information processing, clock resonators composed of piezoelectric resonators made of lithium tantalate, lithium niobate, or piezoelectric ceramics have been used, depending on applications, in addition to the crystal resonators made of quartz.

Amid rapid changes toward smaller sizes, smaller weights, higher performance and lower costs, it is becoming difficult to satisfy tougher requirements with conventional crystal resonators. So far, improvements have been made in circuit designs to find optimum oscillation circuits so as to enhance the performance and function of the entire crystal oscillation circuit. To achieve lower costs, manufacturers have been attempting to curtail the number of parts found in crystal resonators. Parallel to these efforts, in the aspect of production engineering, to reduce the cost of assembling and inspection, automated manufacturing facilities have been utilized. With conventional technical approaches, however, limits are being reached in terms of both development and manufacture. In the crystal resonators mentioned above, the piezoelectric plate has odd-numbered harmonic oscillation modes such as the third, fifth and seventh harmonics at the same time in addition to the fundamental mode which is the inherent oscillation mode determined by the thickness of the quartz plate. As an oscillation circuit, the fundamental oscillation is normally chosen and used, but to achieve higher frequencies, a specific overtone mode may be selected. If the third harmonic is used, the fundamental mode, fifth and seventh harmonics would also be present as spurious oscillations. Accordingly, higher harmonic modes are mixed in the oscillation output, and when the oscillation is unstable, the resonator may variably resonate at the fundamental frequency and then also at the fifth harmonic due to what is called a jumping phenomenon. Similar phenomena may also occur in the piezoelectric resonator made of materials other than quartz, such as lithium tantalate, lithium niobate, or piezoelectric ceramics. In an attempt to suppress the fundamental mode in the third harmonic crystal resonator, certain manufacturers use special shapes for the quartz plate which forms the crystal resonator or use additional electrodes. However, it has not been possible to fully satisfy various requirements at once.

### Brief Summary of the Invention

The present inventor has succeeded in devising means for suppressing all overtone harmonic modes in crystal or piezoelectric resonators so as to have a single oscillation of the fundamental mode. An object of the present invention is to provide a piezoelectric resonator of high performance having a single fundamental mode with suppressed overtone harmonic oscillations.

The piezoelectric resonator of the present invention utilizes the energy trapping phenomenon of the thickness mode oscillation in the piezoelectric plate. The charge distributions at the electrodes induced by overtone harmonic oscillations are different from that generated by the fundamental mode directly underneath the electrodes. That is, charges generated by the fundamental mode are more broadly spread relative to the oscillation region at the electrode than those associated with the higher harmonic oscillations and cover the entire electrodes.

In order to solve the problems of the conventional art, the present invention employs the following electrode structure.

To achieve the above-mentioned object, the present invention provides a piezoelectric resonator comprising a piezoelectric plate, an outer circular or rectangular electrode and an inner electrode disposed with a gap therebetween on the opposite sides of the piezoelectric plate, and a lead electrode connected to the outer electrode electrodes.

The inner electrode is a floating electrode and is not electrically connected with other conductive parts. With this configuration, thickness oscillations are induced within a piezoelectric plate between the two sets of the inner and outer electrodes formed on the opposite sides of the piezoelectric plate. Also, the inner and outer electrodes are not generally limited to any particular shapes. Preferably, however, rectangular or circular shapes can be adopted. The outer electrode forms a closed loop around the inner electrode, and the lead electrode is electrically connected to the outer electrode for outputting signals to the outside of the resonator.

In the electrode structure of the piezoelectric resonator of the present invention, the inner electrodes are formed at the center of the piezoelectric plate. A gap is provided to surround the inner electrode, and an outer electrode is disposed on the piezoelectric plate outside the inner electrode and the gap. Since the piezoelectric material is not an electric conductor, there is no direct electrical connection between the inner and outer electrode although they electrochemically interact with each other. With this outer electrode, the electric charges induced by the fundamental mode are picked up and taken out, so that a resonator is formed. The function of the floating electrode (i.e., the inner electrode) disposed in the center is to entrap the energy of the thickness oscillation modes. That is, part of charges associated with the fundamental oscillation induced in the center and almost all charges associated with overtone harmonic modes are collected at the floating electrode. These charges are not removed because the inner electrode is "floating" without substantial electric connection, and therefore harmonic components (third, fifth, seventh harmonics, etc.) are suppressed. The outer electrode, at which part of charges induced by the fundamental mode are collected, in fact has an equivalent series resistance which is sufficient for practical use by properly selecting the electrode size and thickness.

### Brief Description of the Drawings

Fig. 1 is a plan view of a structure of a piezoelectric resonator.
Fig. 2 is a sectional view of principle of operation of the piezoelectric resonator.
Fig. 3 is a frequency characteristic diagram of piezoelectric resonator.

### Detailed Description of the Invention

An embodiment of the present invention is described below, referring to the drawings.

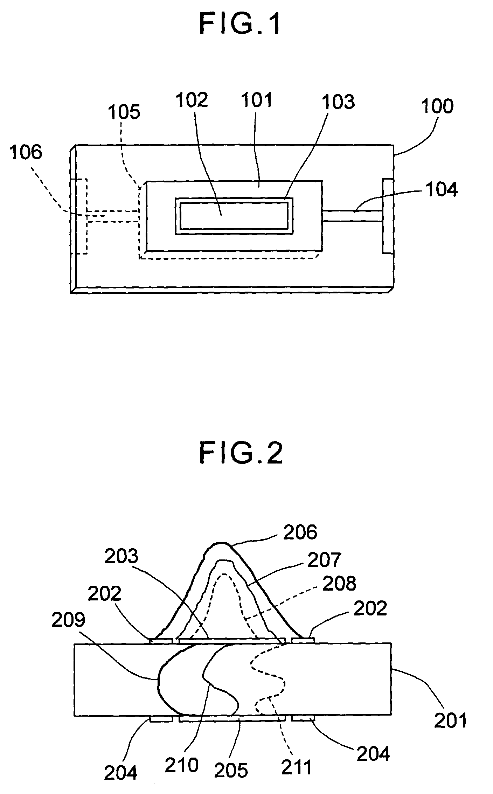

Fig. 1 is a plan view of a piezoelectric resonator of the present invention. On a piezoelectric plate 100 (made, for example, of quartz, lithium tantalate, lithium niobate, or piezoelectric ceramics), an inner electrode 101 and an outer electrode 102 which have a rectangular shape are disposed with a gap 103 formed therebetween, and a lead electrode 104 is connected to the outer electrode 101 which is disposed to surround the inner electrode. On the back face of the piezoelectric plate, another outer electrode 105 and another lead electrode 106 are similarly provided in an symmetric manner with respect to the front face. The lead electrodes 104, 106 are to connect the outer electrode 101, 105 to any outside circuitry which is not shown in Fig. 1. In this particular embodiment, the inner and outer electrodes have rectangular shapes.

Fig. 2 is a sectional view of the piezoelectric resonator for explaining the principle of operation of the present invention. On the opposite faces of the piezoelectric plate 201, electrodes 202, 203, 204, 205 which have a rectangular outer shape are formed by vapor deposition or sputtering. Gaps are present between the outer and inner electrodes 202, 203 and between the outer and inner electrodes 204, 205 so that electric conduction may not substantially occur between the neighboring electrodes. Thickness oscillation modes excited by the inner electrodes 202 and 204, that is, the fundamental mode 209, the third harmonic mode 210, and the fifth harmonic mode 211 are present in the thickness direction of the piezoelectric plate. Induced charges accompanying these oscillation modes have distribution pattern 206 corresponding to the fundamental mode, pattern 207 corresponding to the third harmonic mode, and pattern 208 corresponding to the fifth harmonic mode at the upper and lower electrodes. As we can see clearly also from Fig. 2, part of charges associated with the fundamental, third and fifth harmonic modes generated at the electrodes 203, 205 are also present at the floating electrodes. On the other hand, part of the charges associated with the fundamental mode generated at the electrodes 202, 204 can be picked up and brought outside through the lead electrode, so that the characteristics of the fundamental mode only, ideally speaking, may be obtained.

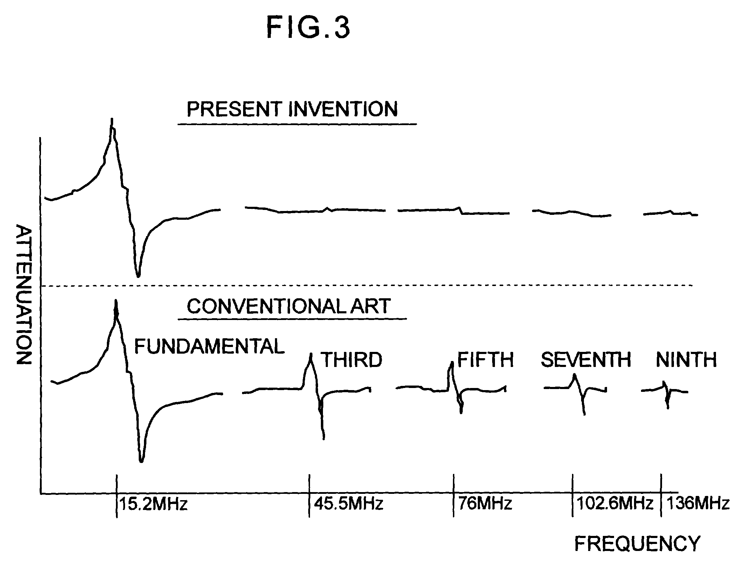

A specific example of the present invention is described below while referring to Fig. 3. This is an example of crystal resonator with the center frequency of 15.2 MHz. On a 3 x 5 mm quartz plate, a silver electrode (corresponding to electrode 101 in Fig. 1) whose size was 2 x 3 mm was formed with a deposited film thickness of 1500 angstroms, and across a gap of 0.2 mm, a 1 x 2 mm rectangular silver electrode (corresponding to electrode 102 in Fig. 1) was formed with a film thickness of 1500 angstroms in the center part of the piezoelectric plate.

The frequency characteristic of the crystal resonator of the present invention obtained in this example is shown in Fig. 3. The wave appearing in response to the fundamental mode is quite outstanding, but the responses due to higher harmonics are very weak. Fig. 3 also shows the frequency characteristics of the conventional crystal resonator composed by forming a silver electrode of 2 x 3 mm in size with a film thickness of 1500 angstroms on a quartz plate of 3 x 5 mm. In the conventional crystal resonator, in addition to the fundamental mode, responses caused by higher harmonic modes were clearly recorded around 45.5 MHz for the third harmonic mode, around 76 MHz for the fifth harmonic mode, around 102.6 MHz for the seventh harmonic mode, and around 136 MHz for the ninth harmonic mode. As we can see from this embodiment and data shown in Fig. 3, with the crystal resonator of the present invention, the third, fifth, seventh, and ninth harmonic waves can be strongly suppressed.

It has been also confirmed that harmonic oscillation modes of the eleventh and higher are suppressed as well.

As described herein, the crystal resonator of the present invention is a piezoelectric resonator having electrodes for inducing charge excitations within the thickness of a piezoelectric plate, wherein the electrodes are formed on upper and lower faces of the piezoelectric plate and have a double configuration in which the inner electrode and the band-shaped outer electrode surrounding the inner electrode with a gap disposed therebetween, the inner electrode has a floating electrode, and a lead electrode is connected to the outer electrode. The inner and outer electrodes can generally have round, circular or rectangular outer shapes. Therefore, with an extremely simple electrode structure, it is possible to suppress the jumping phenomenon among harmonic oscillation modes and jitter which have been found troubling in the conventional crystal resonators. The piezoelectric resonator system formed by using the piezoelectric resonator of the present invention is capable of producing an oscillation output of extreme stability and high purity. Therefore, it does not require a filter which has often been required to suppress undesired spurious modes in the output. Moreover, as it is obvious to those skilled in the art, this invention can be also applied to the piezoelectric resonator which makes use of the trapping phenomenon of energy ascending type.

## Claims

1. A piezoelectric resonator having a piezoelectric plate and electrodes formed on opposite sides of the piezoelectric plate so as to induce thickness oscillations within the piezoelectric plate, wherein said electrodes comprises an inner electrode, an outer electrode disposed around the inner electrode with a gap therebetween, and a lead electrode connected to the outer electrode.

2. The piezoelectric resonator according to claim 1, wherein the outer and inner electrodes have a rectangular outer shape, and the outer electrode forms a closed loop around the inner electrode.

3. The piezoelectric resonator according to claim 1, wherein the outer and inner electrodes have a circular shape, and the outer electrode forms a closed loop around the inner electrode.
